# EUROPEAN PATENT APPLICATION

(11) **EP 4 786 283 A1**
(43) Date of publication of application: **05.08.2026**
(21) Application number: 24871037.8
(22) Date of filing: 27.09.2024
(51) Int. Cl.: B60R 16/02, H05K 5/02, H05K 5/06

(54) **REGION CONTROL APPARATUS FOR VEHICLE, AND VEHICLE**

(30) Priority: 28.09.2023 CN 202311283396
(71) Applicant: Valeo Schalter und Sensoren GmbH, 74321 Bietigheim-Bissingen (DE)
(72) Inventor: JIANG, Luyao, Shenzhen, Guangdong 518128 (CN); ZHU, Hu, Shenzhen, Guangdong 518128 (CN); SUN, Xiaoqing, Shenzhen, Guangdong 518128 (CN)
(74) Representative: Valeo Schalter und Sensoren
(86) International application number: PCT/CN2024/122001
(87) International publication number: WO 2025/067502

(57) **Abstract**

The disclosure provides a region control device for a vehicle and the vehicle. The region control apparatus comprises: a housing (1), which is internally provided with a circuit board (2); and a metal connecting member (3), which is integrated with the housing (1), wherein a first end (31) of the metal connecting member (3) is electrically connected to an external circuit, and a second end (32) is electrically connected to the circuit board (2).

## Description

### TECHNICAL FIELD

The present disclosure relates to a region control apparatus for a vehicle, and a vehicle.

### BACKGROUND

Regional architecture enables efficient electrical and data distribution around a vehicle, while reducing wiring costs, improving weight optimization, and streamlining production processes. A key component of this architecture is a region controller, which is responsible for connecting numerous actuators and sensors to a central control unit, and providing power distribution, data connectivity, and I/O acquisition and drive requirements for the sensors, the actuators, and other devices within a physical region.

Generally, the region controller includes a circuit board, and a housing enclosing the circuit board. The sensors, the actuators, and other devices are disposed on the circuit board, and these devices are electrically connected to various external devices via electrical connecting members passing through the housing. The region controller includes a front compartment region controller and a cabin region controller. For example, the front compartment region controller is typically mounted at the bottom of the vehicle, is exposed to dust and water environments during operation of the vehicle, and therefore requires good sealing to ensure a sufficient dustproof and waterproof rating. An existing solution is to seal the housing by placing a silicone gasket between the electrical connecting member and the housing, but this solution is ineffective. In terms of electrical functionality, the region controller also needs to meet certain requirements for high conductivity and ensure reliable electrical connection. An existing solution uses soldering to achieve electrical connection, but this approach is prone to failure due to high temperatures.

### SUMMARY OF THE INVENTION

Therefore, an objective of the present disclosure is to provide a region control apparatus for a vehicle and a vehicle. The region controller has good sealing performance and high dustproof and waterproof effects, and realizes high conductivity and reliable electrical connection.

The aforementioned objective is achieved through a region control apparatus for a vehicle, and a vehicle, which are described below.

The present disclosure provides a region control apparatus for a vehicle, the region control apparatus including: a housing, in which a circuit board is provided; and a metal connecting member formed in one piece with the housing, where a first end of the metal connecting member is electrically connected to an external circuit, and a second end is electrically connected to the circuit board.

In one implementation, the metal connecting member is at least partially encased in the housing.

In one implementation, the first end of the metal connecting member is provided with at least one circumferential groove separate from each other, and the housing fills the circumferential groove.

In one implementation, the second end of the metal connecting member has a flat top surface, and the second end is electrically connected to the circuit board via the top surface.

In one implementation, the second end of the metal connecting member is provided with a mounting hole which is open on the top surface, and the circuit board is fixed to the metal connecting member via a fastener which mates with the mounting hole.

In one implementation, the metal connecting member is in the form of a column, which extends in a direction perpendicular to a side wall of the housing.

In one implementation, an end face of the first end of the metal connecting member is provided with an external connecting member, and the external circuit is electrically connected to the metal connecting member via the external connecting member.

In one implementation, the external connecting member is fixed to the end face of the first end of the metal connecting member via a further fastener.

In one implementation, the housing includes a main body made of plastic and a cover made of metal, and the metal connecting member is at least partially encased in the main body.

The present disclosure further provides a vehicle, including a region control apparatus as described above.

The embodiments of the present disclosure have the following advantages: by forming the metal connecting member in one piece with the housing, not only can a good sealing effect be achieved so that the region control apparatus has a high dustproof and waterproof rating, but also the use of additional components can be reduced, making the structure simple, easy to manufacture and inexpensive; by using the metal connecting member in the form of a copper column with a large conductive area, the region control apparatus can achieve high conductivity; and by using threaded connection to replace conventional soldering for electrical connection, a more reliable electrical connection can be achieved, and the electrical connection is detachable, providing greater flexibility.

### BRIEF DESCRIPTION OF THE DRAWINGS

A better understanding of the advantages and objective of the present disclosure can be gained from the preferred implementations of the present disclosure described in detail below with reference to the drawings. To better illustrate the relationships between components in the drawings, the drawings are not drawn to scale. In the drawings:
Fig. 1 shows a schematic view of a region control apparatus for a vehicle according to an embodiment of the present disclosure;
Fig. 2 shows a schematic exploded view of the region control apparatus in Fig. 1;
Fig. 3 shows a partial schematic view of a region control apparatus according to an embodiment of the present disclosure;
Fig. 4 shows a partial schematic view of a region control apparatus according to an embodiment of the present disclosure;
Fig. 5 shows a partial schematic view of a region control apparatus according to an embodiment of the present disclosure;
Fig. 6 shows a schematic view of a metal connecting member and an external connecting member of a region control apparatus according to an embodiment of the present disclosure; and
Fig. 7 shows a schematic view of a metal connecting member of a region control apparatus according to an embodiment of the present disclosure.

### DETAILED DESCRIPTION OF THE EMBODIMENTS

In order to clarify the objective, technical solutions and advantages of the present disclosure, the technical solutions of the embodiments of the present disclosure are described clearly and completely below in conjunction with the drawings accompanying the particular embodiments of the present disclosure. The same reference signs in the drawings refer to the same components. It must be explained that the embodiments described are some, not all, of the embodiments of the present disclosure. All other embodiments obtained by those skilled in the art based on the described embodiments of the present disclosure without the need for inventive effort shall fall within the scope of protection of the present disclosure.

Unless otherwise defined, the technical or scientific terms used herein shall have the common meanings understood by those skilled in the art. The words "first", "second", and the like used in the description and claims of the patent application disclosed herein do not indicate any order, quantity or importance, being merely used to distinguish different component parts. Likewise, words such as "a" or "one" do not necessarily represent a quantity limit. Words such as "comprising", "including" or "having" mean that the element or object preceding the word covers the elements or objects and equivalents thereof listed after the word, without excluding other elements or objects. Words such as "connection" or "communication", rather than being limited to the physical or mechanical connection or communication shown in a drawing, may include connection or communication equivalent thereto, irrespective of whether it is direct or indirect. "Upper", "lower", "left", "right", etc. are merely used to indicate a relative positional relationship; when the absolute position of a described object changes, the relative positional relationship may also change accordingly.

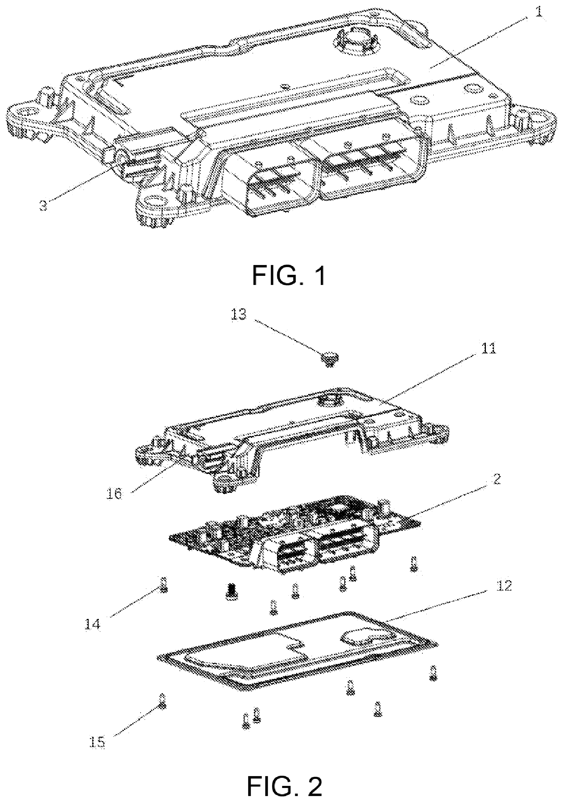

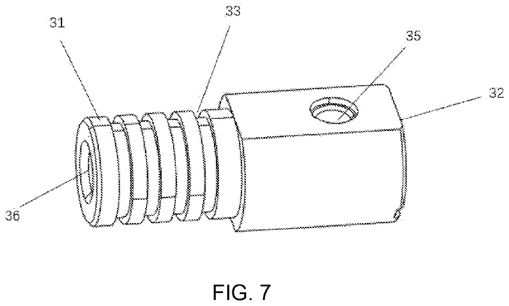

Various embodiments of the present disclosure will be described in detail below with reference to Figs. 1 to 7.

As shown in Fig. 1, a region control apparatus for a vehicle of the present disclosure includes a housing 1 and a metal connecting member 3. The metal connecting member 3 may be made of copper.

As shown in Fig. 2, the housing 1 is provided with a circuit board 2 on which various sensors, actuators, and other devices are mounted. Furthermore, the housing 1 includes a main body 11 made of plastic and a cover 12 made of metal. The cover 12 may be made of aluminum. The main body 11 may be made of PBT, glass fiber or a high-temperature-resistant plastic material. The circuit board 2 is mounted on the main body 11 by means of a threaded fastener 14, and the cover 12 is mounted on the main body 11 by means of a further threaded fastener 15. A seal such as a sealant may be provided at a contact position between the main body 11 and the cover 12, which will not be described in detail herein. In addition, a thermally conductive element, such as a thermally conductive adhesive, may be provided between the cover 12 made of metal and the circuit board 2. The housing 1 further includes a valve 13, which may be in particular a waterproof and breathable valve, for providing waterproofing and maintaining the pressure balance between the inside and outside of the region controller.

As shown in Figs. 1 to 7, the metal connecting member 3 is formed in one piece with the housing 1. A first end 31 of the metal connecting member 3 is electrically connected to an external circuit, and a second end 32 is electrically connected to the circuit board 2. The external circuit may be a circuit on the vehicle that is external to the region controller, such as a main power supply for the region control control apparatus.

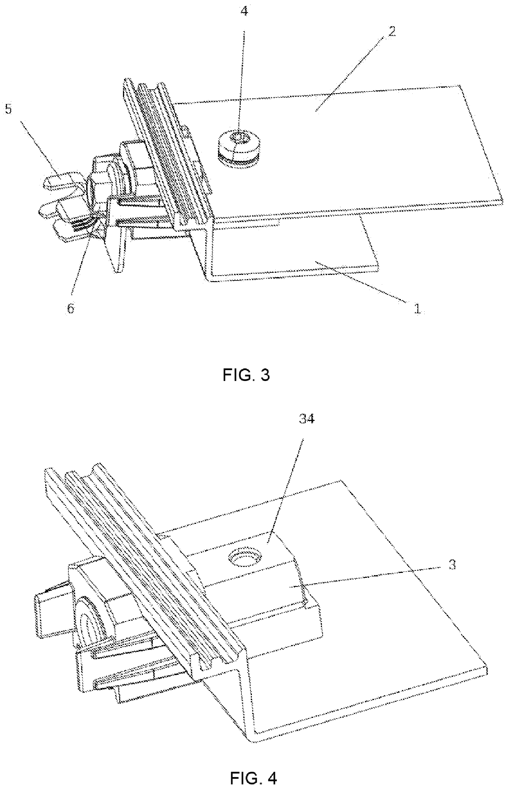

As shown in Fig. 4, the metal connecting member 3 is at least partially encased in the housing 1. Specifically, the metal connecting member 3 is at least partially encased in the main body 11 of the housing 1 that is made of plastic. For example, the metal connecting member 3 is encased in the main body 11 by injection molding.

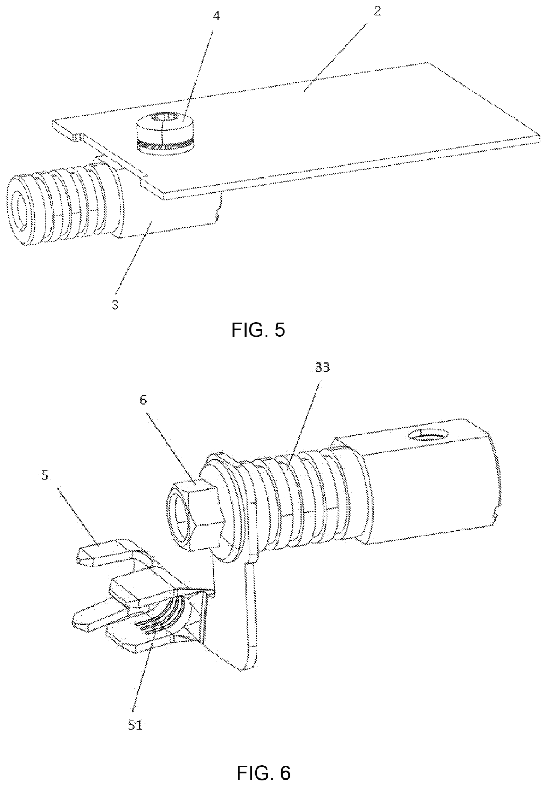

As shown in Figs. 6-7, the first end 31 of the metal connecting member 3 is provided with at least one circumferential groove 33 separate from one another, and the housing 1 fills the circumferential groove 33. Specifically, the main body 11 made of plastic fills the circumferential groove 33 by injection molding. The number of circumferential grooves 33 may be two, three, preferably four. In addition, the plurality of circumferential grooves 33 are separate from each other and are not in communication with each other.

As shown in Figs. 6-7, the metal connecting member 3 is in the form of a column. As shown in Figs. 1-4, the metal connecting member 3 extends in a direction perpendicular to a side wall 16 of the housing 1, and the metal connecting member 3 extends through the side wall 16.

By forming the metal connecting member 3 in one piece with the housing 1, not only can a good sealing effect be achieved so that the region control apparatus has a high dustproof and waterproof rating, but also the use of additional components can be reduced, making the structure simple, easy to manufacture and inexpensive. For example, the region control apparatus of the present disclosure may achieve a dustproof and waterproof rating of IP67. In addition, by using the metal connecting member in the form of a copper column with a large conductive area, the region control apparatus of the present disclosure can achieve high conductivity. For example, the region control apparatus of the present disclosure may enable high current conduction of 80A.

As shown in Figs. 4 and 6 to 7, the second end 32 of the metal connecting member 3 has a flat top surface 34. As shown in Figs. 3 and 5, the second end 32 is electrically connected to the circuit board 2 via the top surface 34. In this way, a surface contact is achieved between the metal connecting member 3 and the circuit board 2 of the present disclosure.

Referring again to Figs. 4 and 6 to 7, the second end 32 of the metal connecting member 3 is provided with a mounting hole 35. The mounting hole 35 is open on the top surface 34. As shown in Figs. 3 and 5, the circuit board 2 is fixed to the metal connecting member 3 via a fastener 4 which mates with the mounting hole 35. For example, the fastener 4 may be a screw, a bolt, etc.

Compared to the conventional connection methods using soldering, the present disclosure does not damage surrounding circuit connections due to the high temperature of soldering, so that a more reliable electrical connection can be achieved, and the electrical connection of the present disclosure is detachable, providing greater flexibility.

As shown in Figs. 3 and 6, an end face of the first end 31 of the metal connecting member 3 is provided with an external connecting member 5, and the external circuit described above is electrically connected to the metal connecting member 3 via the external connecting member 5. The external connecting member 5 may be a clamping member having a shape matching a cable, for example, having a claw shape. The external connecting member 5 can clamp the cable.

As shown in Figs. 3 and 6, the external connecting member 5 is fixed to the end face of the first end 31 of the metal connecting member 3 via a further fastener 6. At the end face of the first end 31 of the metal connecting member 3, a further mounting hole 36 is provided which extends to the interior of the metal connecting member 31. The further fastener 6 is a screw, a bolt, etc., and the further mounting hole 36 is a threaded hole. By using the threaded connection, problems caused by high-temperature soldering can be avoided, making the electrical connection more reliable, and the electrical connection is detachable, providing greater flexibility, as described above.

The present disclosure further provides a vehicle, including a region control apparatus as described above. The vehicle may be an electrified vehicle, such as a battery electric vehicle (BEV), a hybrid electric vehicle (HEV), a plug-in hybrid electric vehicle (PHEV), a range extended (EV) or a fuel cell electric vehicle (FCEV). The vehicle may also be a hydrogen vehicle. The vehicle of the present disclosure thus has the advantages described above in relation to the region controller.

In addition, the technical features disclosed above are not limited to combinations of the disclosed features with other features, and those skilled in the art could combine technical features in other ways according to the objective of the invention, to realize the objective of the present disclosure.

## Claims

1. A region control apparatus for a vehicle, **characterized in that** the region control apparatus comprises:
a housing (1), in which a circuit board (2) is provided; and
a metal connecting member (3) formed in one piece with the housing (1),
wherein a first end (31) of the metal connecting member (3) is electrically connected to an external circuit, and a second end (32) is electrically connected to the circuit board (2).

2. The region control apparatus according to claim 1, **characterized in that** the metal connecting member (3) is at least partially encased in the housing (1).

3. The region control apparatus according to claim 1 or 2, **characterized in that** the first end (31) of the metal connecting member is provided with at least one circumferential groove (33) separate from each other, and the housing (1) fills the circumferential groove (33).

4. The region control apparatus according to claim 1 or 2, **characterized in that** the second end (32) of the metal connecting member (3) has a flat top surface (34), and the second end (32) is electrically connected to the circuit board (2) via the top surface (34).

5. The region control apparatus according to claim 4, **characterized in that** the second end (32) of the metal connecting member (3) is provided with a mounting hole (35) which is open on the top surface (34), and the circuit board (2) is fixed to the metal connecting member (3) via a fastener (4) which mates with the mounting hole.

6. The region control apparatus according to claim 1 or 2, **characterized in that** the metal connecting member (3) is in the form of a column, which extends in a direction perpendicular to a side wall (16) of the housing (1).

7. The region control apparatus according to claim 1 or 2, **characterized in that** an end face of the first end (31) of the metal connecting member (3) is provided with an external connecting member (5), and the external circuit is electrically connected to the metal connecting member (3) via the external connecting member.

8. The region control apparatus according to claim 7, **characterized in that** the external connecting member (5) is fixed to the end face of the first end (31) of the metal connecting member via a further fastener (6).

9. The region control apparatus according to claim 1 or 2, **characterized in that** the housing (1) comprises a main body (11) made of plastic and a cover (12) made of metal, and the metal connecting member (3) is at least partially encased in the main body (11).

10. A vehicle, **characterized by** comprising a region control apparatus according to any one of claims 1 to 9.
